# EUROPEAN PATENT SPECIFICATION

(11) **EP 0 782 200 B1**
(45) Date of publication and mention of the grant of the patent: **26.09.2001**
(21) Application number: 96309339.8
(22) Date of filing: 20.12.1996
(51) Int. Cl.: H01L 29/74, H01L 27/08, H01L 27/12, H01L 27/06

(54) **A silicon controlled rectifier built in polysilicon**
Silizium-Gleichrichter aus Polysilizium
Redresseur commandé au silicium formé en polysilicium

(30) Priority: 27.12.1995 US 579514; 27.12.1995 US 579513
(43) Date of publication of application: 02.07.1997
(73) Proprietor: XEROX CORPORATION, Rochester, New York 14644 (US)
(72) Inventor: Ahmed, Iftikhar, A81, Bellflower, California 90706 (US); Buhler, Steven A., Redondo, California 90278 (US)
(74) Representative: Grünecker, Kinkeldey, Stockmair & Schwanhäusser Anwaltssozietät

(56) References cited:
- EP-A- 0 255 968
- JP-A- 54 105 483
- US-A- 5 473 169
- PATENT ABSTRACTS OF JAPAN vol. 003, no. 127 (E-146), 23 October 1979 & JP 54 105483 A (MITSUBISHI ELECTRIC CORP), 18 August 1979,
- PATENT ABSTRACTS OF JAPAN vol. 004, no. 165 (E-034), 15 November 1980 & JP 55 115340 A (HITACHI LTD), 5 September 1980,

## Description

This invention relates generally to a silicon controlled rectifier (SCR) device according to the preamble of claim 1.

A SCR having the elements as shown in the preamble of claim 1 are known from JP-A-54-105483.

A lateral SCR formed on a polysilicon substrate and with a resistor connected between the p-base and the n-emitter is known from JP-A-55-115 340.

Devices, such as stacked or cascaded transistors, have been used to turn on extremely high voltages, however structures of this type are inherently long, consume large amounts of silicon and have reliability problems. There has not been a single device that can be used to turn on extremely high voltages for example, voltages of 20,000 volts or more.

Conventional SCRs can be used as specialized switches. One important aspect of designing SCRs is that there is no upward limit on the number of p-n junctions which can be combined to form an SCR device. Increasing the number of p-n junctions in an SCR allows design of a single high voltage device that can be used as a switch.

New processing technologies have led to the development of an ability to build a reasonably good SCR device in layers above that of transistors built within substrate layers of a wafer. Utilizing SCR characteristics to build a single device as a high voltage switch and then building the SCR in the layers above that of conventional transistors has led to the development of a single high voltage switch that does not use the large quantities of area required for conventional high voltage switches.

Accordingly, it is the primary aim of the invention to provide a single high voltage device capable of switching high voltages and not requiring large quantities of silicon area.

Further advantages of the invention will become apparent as the following description proceeds.

According to the present invention, there is provided a silicon controlled rectifier comprising: the features as set out in claim 1.

Briefly stated and in accordance with the present invention, there is provided a silicon controlled rectifier which is built on a substrate that has been covered with an insulating layer. A layer of polysilicon is deposited on the insulating layer, and the silicon controlled rectifier is built in the polysilicon layer. The gate, cathode, anode, and a voltage sustaining area make up the silicon controlled rectifier and they are linearly arranged such that the cathode is on one end, the gate is contiguous to the cathode, the voltage sustaining area is contiguous to the gate, and terminates with the anode, with the anode contiguous to the voltage sustaining area and on the other end.

According to the present invention, there is provided a high voltage silicon controlled rectifier switch comprising: an electrical series comprised of n unit silicon controlled rectifiers as described above, wherein n is an integer of at least 2 and each unit rectifier is uniquely numbered with an integer between 1 and n, the unit rectifier numbered 1 being a first unit and the unit rectifier numbered n being a last unit, a voltage source node, n resistors each uniquely numbered with an integer between 1 and n, the resistor numbered 1 being a first resistor and the resistor numbered n being an nth resistor, each resistor having a first end and a second end, and is associated with a single unit rectifier to form a resistor-unit silicon controlled rectifier pair, the cathode of the first unit rectifier being electrically connected to the first end of the first resistor and the anode of the nth unit rectifier being electrically connected to the second end of the nth resistor and to the voltage source node, each ith unit rectifier having its anode electrically connected to and at least partially contiguous with the cathode of the (i+1)th unit rectifier, where i is every integer between 1 and n-1 inclusive and each ith resistor having its second end electrically connected to the gate of the (i+1)th unit rectifier and to the first end of the (i+1)th resistor.

There is also provided a high voltage SCR switch that is an electrical series of multiple unit SCRs. Each unit SCR comprises a cathode region, a gate region, an anode region and a voltage sustaining area. These regions are linearly arranged such that the cathode regions is on one end, the gate region is contiguous to the cathode region, the voltage sustaining area is contiguous to the gate region, and the unit SCR terminates with the anode region, the anode region being contiguous to the voltage sustaining area and on the other end. Also part of the high voltage SCR switch are multiple resistors forming a resistor voltage divider network.

For a better understanding of the present invention, reference will now be made, by way of example only, to the accompanying drawings in which:-
Figure 1 shows a schematic of a high voltage SCR switch utilizing two unit SCR blocks;
Figure 2 shows a schematic of a high voltage SCR switch utilizing a multiple number of unit SCR blocks;
Figure 3 shows a top view of a layout of the SCR shown in Figure 1; and
Figure 4 shows a cross-section of the layout shown in Figure 3 taken through cross-section line 4-4.

SCRs have been known and used in power and switching circuits since the late 1960's. SCR theory and the operation of SCRs is well known. The SCR switch discussed in this application does not operate substantially differently from SCR theory, therefore attention will be focused on the design, layout, and processing parameters which enable this disclosed SCR to be used as a single device capable of switching high voltages and not requiring the use of additional silicon area to be fabricated as part of a circuit.

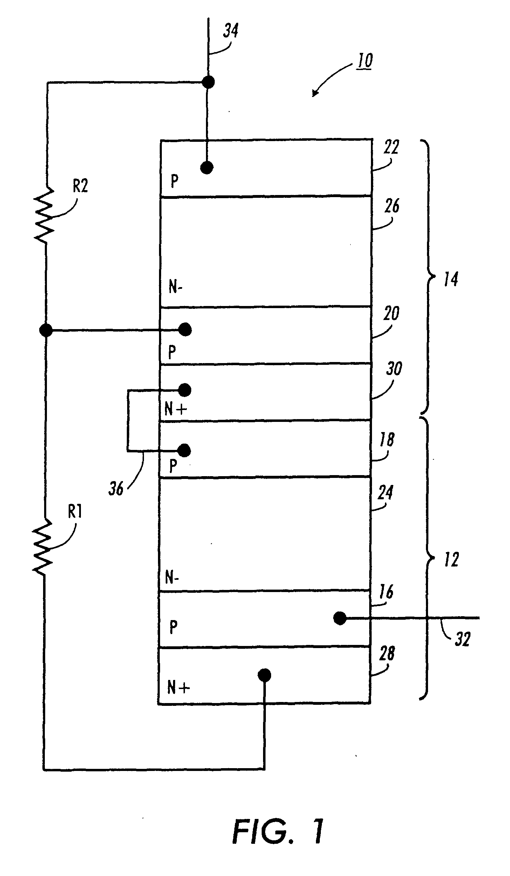

Turning now to Figure 1, a schematic of an SCR switch 10 is shown. The SCR switch 10 has two unit SCRs 12, 14. Each unit SCR 12, 14 is composed of two p type areas 16, 18, 20, 22 alternating with either a voltage sustaining area 24, 26 or a n⁺ type area 28, 30.

Line 32 is an electrical connection to the p type area 16 that is the gate of the unit SCR 12. This is the p type area interposed between the voltage sustaining area 24 and the n⁺ type area 28 of unit SCR 12. The other p type area 18 is the anode of the unit SCR 12. The n⁺ type area 28 is the cathode of the unit SCR 12.

The p type area 20 is the gate of the unit SCR 14. The p type area 22 is the anode of the unit SCR 14 and the n+ type area 30 is the cathode of the unit SCR 14.

Line 34 is a voltage source line for the SCR switch 10. It is connected in parallel to the anode (p type area 22) of the unit SCR 14 and to a resistor R1. The other end of the resistor R1 is connected in parallel to the gate (p type area 20) of the unit SCR 14 and to a resistor R2. The other end of resistor R2 is connected to the cathode (n⁺ type area 28) of the unit SCR 12. The resistors R1 and R2 form a voltage divider to divide the supply voltage on line 34 between the two unit SCRs 12, 14.

Unit SCR 12 is electronically connected directly to unit SCR 14 by connecting the anode (p type area 18) of unit SCR 12 to the cathode (n⁺ type area 30) of unit SCR 14 through line 36.

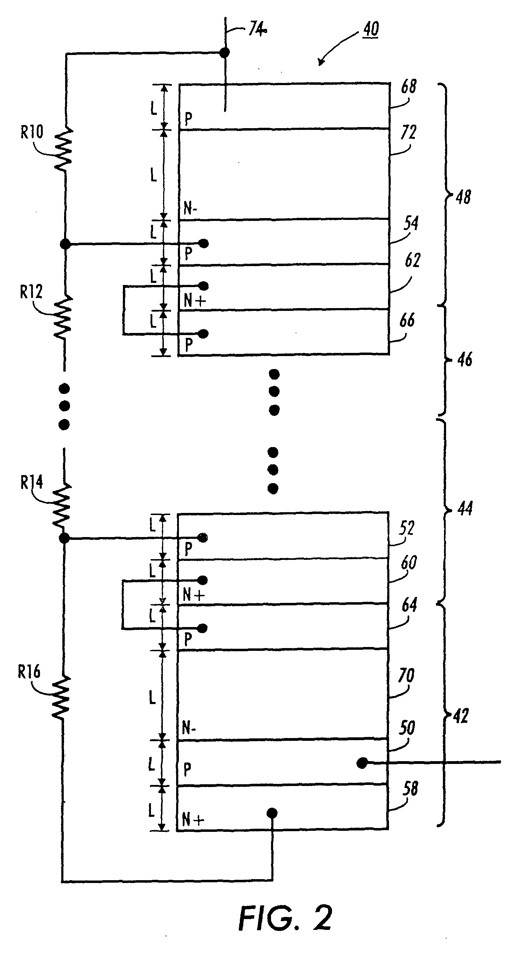

Figure 1 shows how two unit SCRs 12, 14 may be connected together along with a voltage divider network to allow each unit SCR 12, 14 to share the total voltage and increase the voltage capability of the resultant SCR switch 10. However, this technique is not limited to using just two unit SCRs. Figure 2 shows an example of multiple unit SCRs connected together to form a single high voltage switch.

In Figure 2, a high voltage SCR switch 40 is shown. It is comprised of an n number of unit SCRs 42, 44, 46, 48 where unit SCR 42 is the first unit SCR, unit SCR 44 is the second unit SCR, unit SCR 46 is the nth-1 unit SCR and unit SCR 48 is the nth or last unit SCR. The two unit SCRs 42, 48 are shown in their entirety but unit SCRs 44, 46 are only partially shown to illustrate how multiple unit SCRs may be used to form one single SCR switch.

Each unit SCR, as discussed above, has a gate and shown is gate 50 for unit SCR 42, gate 52 for unit SCR 44 and gate 54 for unit SCR 48. Each unit SCR has a cathode and shown is cathode 58 for unit SCR 42, cathode 60 for unit SCR 44 and cathode 62 for unit SCR 48. Each unit SCR has an anode and shown is anode 64 for unit SCR 42, anode 66 for unit SCR 46, and anode 68 for unit SCR 48. Each unit SCR also has a remaining voltage sustaining area and shown is the voltage sustaining area 70 for unit SCR 42 and voltage sustaining area 72 for unit SCR 48. A source voltage will be applied to the high voltage SCR switch 40 at node 74.

A voltage divider network comprised of n number of resistors is also shown. Resistor R16 is the first resistor, resistor R14 is the second resistor, resistor R12 is the nth-1 resistor and resistor R10 is the nth or last resistor. Note that in this configuration, that however many n unit SCRs there are, there are an equal n number of resistors in the voltage divider network.

The first resistor R16 is always attached to the cathode 58 of the first unit SCR 42 on one end and to the gate 52 of the second unit SCR 44 on the other end. The second resistor R14 is attached to the gate 52 of the second unit SCR 44 on one end and the gate of the next unit SCR on the other end (not shown). That is, with the exception of the first and last (or nth) resistors, any ith resistor is attached between the gates of the ith and ith + 1 unit SCRs. The last or nth resistor R10 is attached between the gate 54 of the last or nth unit SCR 48 and the anode 68 of the last or nth unit SCR 48.

The design of the resistors R16, R14, R12, R10 is important to proper functioning of the high voltage SCR switch 40. The resistors R16, R14, R12, R10 need to be designed so that any current flowing through them is low enough to prevent turn on when the gate 50 is grounded and the voltage is ramped up but also with sufficient current to turn on the gate 50 when the high voltage SCR switch is being used in normal operation. This means that the resistance needed will be a relatively large value but it is important to remember that it is the current density that is important in the functioning of the high voltage SCR switch 40 and the current density is a function of the physical device sizes.

Example sizes for the high voltage SCR switch 40 are resistor (R10, R12, R14, R16) values of 10⁸ ohms, with device lengths L of the gates 50, 52, 54, cathodes 58, 60, 62, and anodes 64, 66, 68 in the range of 3 to 10µm. The device length L of the remaining voltage sustaining areas 70, 72 should be in the range of 10 to 50µm. With a source voltage of 1000 volts applied at node 74 there will be a current of 10µA flowing through each resistor R10, R12, R14, R16. With device lengths of approximately 10µm, the current density will be approximately 1µA/µm in width which should be sufficient for operating the high voltage SCR switch 40. However, these are merely example sizes for one high voltage SCR switch to illustrate a sample design. Actual values will vary depending on the size of the high voltage SCR switch used.

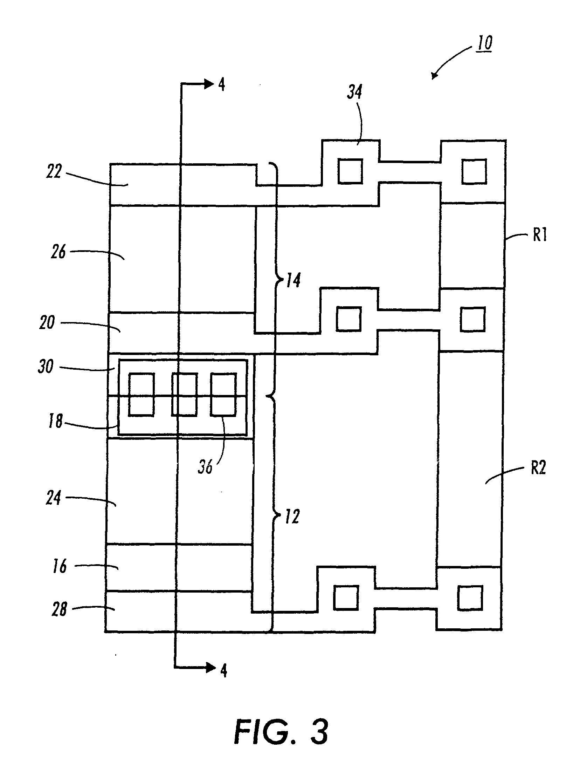

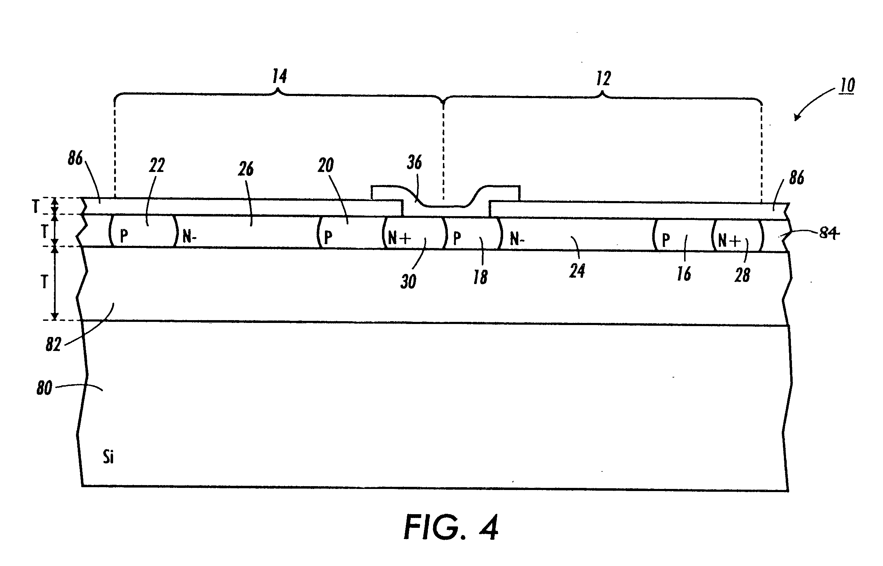

Figure 3 shows a top view of a layout of the high voltage SCR switch 10 shown in Figure 1. Figure 4 shows a cross section of the layout of the high voltage SCR switch taken through line 4-4 shown on Figure 3. The process techniques are well known within the art of semiconductor processing so discussion will focus on materials and final structure of the high voltage SCR switch.

The high voltage SCR switch is built on a substrate 80 as shown in Figure 4. The substrate 80 in this example is a plain silicon wafer, however the substrate 80 could be a variety of things including a pre-processed silicon wafer containing other semiconductor devices, glass, sapphire, quartz or ceramic.

A thick insulating layer 82 is formed on top of the substrate 80 if a silicon wafer is used for the substrate 80. If glass, sapphire, ceramic, or quartz is used for the substrate 80 then the insulating layer 82 may be omitted. The thick insulating layer 82 is to provide an isolation layer between the substrate 80 and the high voltage SCR switch 10. The insulating layer 82 should be approximately from 1 to 2µm thick or thicker to provide the necessary insulation from the high voltages used in the high voltage SCR switch. The necessary minimum thickness of the insulating will vary with the actual voltages expected with a thicker insulating layer 82 being needed for higher voltages. For very high voltage applications, those greater than 2000 volts, it is anticipated that it will not possible to provide a thick enough insulating layer to adequately isolate the substrate 80 from the high voltage SCR switch. In these cases, the appropriate choice of substrate 80 is glass, quartz, ceramic, sapphire or other material that does not require an isolation layer. A variety of good insulators can be used to make the insulating layer 82 including oxide, nitride and oxynitride layers.

The high voltage SCR switch 10 is built in a layer of polysilicon 84 on top of the insulating layer 82. The polysilicon 84 should be from approximately 0.2 to 1.0µm thick. If the polysilicon becomes thinner, the requisite free charge density needed for the high voltage SCR switch 10 to work will not be present. The polysilicon 84 receives a low blanket implant, using conventional techniques, of phosphorus giving it an n- type concentration. Suitable concentrations range from 10¹⁸cm⁻³ to 10¹⁴cm⁻³ with an optimal concentration in the vicinity of 10¹⁵cm⁻³. Using a blanket implant to provide an n- type concentration to the entire polysilicon 84 is used for ease of processing and to reduce the number of masking steps used. The voltage sustaining areas, could be created with conventional masking and implanting techniques.

The p type areas 16, 18, 20, 22 are built in the polysilicon 84 using conventional masking and implant techniques. In this process the use of a blanket n- type implant puts some constraints on the concentrations of dopant used to create the p type areas 16, 18, 20, 22. It requires that the concentrations used to create the p type areas be greater than the concentrations used in the blanket implant. Suitable concentrations range from approximately 10¹⁷ to 10¹⁹cm⁻³.

The n⁺ type areas 28, 30 are created using conventional masking and an additional n type implant to create a resultant concentration of approximately from 10¹⁹ to 10²⁰cm⁻³. The concentration of the result n⁺ type areas 28, 30 should be greater than the concentrations of the p type areas 16, 18, 20, 22.

A thin layer of oxide 86 is grown on top of the polysilicon 84 to protect the high voltage SCR switch 10. The line 36 connecting the n⁺ type area 30 and the p type area 18 is implemented using a metal connection through a space in the oxide 86.

## Claims

1. A silicon controlled rectifier SCR switch (12, 14; 42, 44, 46, 48) comprising:
a substrate (80, 82) with an upper surface, and a silicon layer (84) formed on the substrate (80, 82),
a silicon controlled rectifier SCR unit (12, 14) being formed in said silicon layer, wherein the silicon controlled rectifier unit comprises one gate region (16, 20; 50, 52, 54), one cathode region (28, 30; 58, 60, 62), one anode region (18, 22; 64, 66, 68), and one voltage sustaining region (24, 26; 70, 72), the gate region (16, 20; 50, 52, 54), the cathode region (28, 30; 58, 60, 62), the anode region (18, 22; 64, 66, 68), and the voltage sustaining region (24, 26; 70, 72) being linearly arranged such that the cathode region (28, 30; 58, 60, 62) is at one end of the SCR unit, the gate region (16, 20; 50, 52, 54) is contiguous to the cathode region (28, 30; 58, 60, 62), the voltage sustaining region (24, 26; 70, 72) is contiguous to the gate region (16,20; 50, 52, 54), and the anode region (18, 22; 64, 66, 68) is contiguous to the voltage sustaining region (24, 26; 70, 72) and the anode region (18, 22; 64, 66, 68) terminates at the other end of the SCR unit,
**characterized in that**
said silicon layer is a layer made of polysilicon, and
the SCR switch comprises an electrical series comprised of n unit silicon controlled rectifiers (12, 14; 42, 44, 46, 48), wherein n is an integer of at least 2 and each unit rectifier (12, 14; 42, 44, 46, 48) is uniquely numbered with an integer between 1 and n, the unit rectifier numbered 1 being a first unit and the unit rectifier numbered n being a last unit, a voltage source node (34; 74), n resistors (R1, R2; R10, R12, R14, R16) each uniquely numbered with an integer between 1 and n, the resistor numbered 1 being a first resistor and the resistor numbered n being an nth resistor, each resistor having a first end and a second end, and is associated with a single unit rectifier to form a resistor-unit silicon controlled rectifier pair, the cathode (28; 58) of the first unit rectifier (12; 42) being electrically connected to the first end of the first resistor (R1; R16) and the anode (22; 68) of the nth unit rectifier (14; 48) being electrically connected to the second end of the nth resistor (R2; R10) and to the voltage source node (34; 74), each ith unit rectifier having its anode (18; 64, 66) electrically connected to and at least partially contiguous with the cathode (30; 60, 62) of the (i+1)th unit rectifier, where i is every integer between 1 and n-1 inclusive and each ith resistor (R1; R16, R14, R12) having its second end electrically connected to the gate (20; 52, 54) of the (i+1)th unit rectifier (14; 44, 46, 48) and to the first end of the (i+1)th resistor (R2; R14, R12, R10).

2. The high voltage silicon controlled rectifier switch (10) according to claim 1 comprising an electrical series comprised of first and second unit rectifiers (12, 14).

3. The silicon controlled rectifier switch according to claim 1, wherein the substrate (80, 82) comprises silicon (80) with an insulating layer (82) on the upper surface thereof interposed between the silicon (80) and the layer (84) of polysilicon.

4. The silicon controlled rectifier switch according to claim 3, wherein the insulating layer comprises one of the following: an oxide, a nitride or an oxynitride.

5. The silicon controlled rectifier switch according to claim 1, wherein the substrate (80) comprises one of the following materials: glass, ceramic, quartz or sapphire.

6. The silicon controlled rectifier switch according to any one of claims 1 to 5, wherein the gate region (16, 20; 50, 52, 54), and the anode region (18, 22; 64, 66, 68) have dopant concentrations of between approximately 10¹⁷ and 10¹⁹cm⁻³.

7. The silicon controlled rectifier switch according to any one of claims 1 to 6, wherein the cathode region (28, 30; 58, 60, 62), has dopant concentrations of between approximately 10¹⁹ and 10²⁰cm⁻³.

8. The silicon controlled rectifier switch according to claim 1, wherein the voltage sustaining region (24, 26; 70, 72) has dopant concentrations of between approximately 10¹⁸ and 10¹⁴ cm⁻³.

## Patentansprüche

1. Ein Siliziumgleichrichter-SCR-Schalter (12,14;42,44,46,48) mit:
einem Substrat (80,82) mit einer oberen Oberfläche und einer auf dem Substrat (80,82) gebildeten Siliziumschicht (84),
einer Siliziumgleichrichter-SCR-Einheit (12,14), die in der Siliziumschicht gebildet ist, wobei die Siliziumgleichrichtereinheit ein Gategebiet (16,20;50,52,54), ein Kathodengebiet (28,30;58,60,62), ein Anodengebiet (18,22;64,66,68) und ein Spannungserhaltungsgebiet (24,26;70,72) umfasst, wobei das Gategebiet (16,20;50,52,54), das Kathodengebiet (28,30;58,60,62), das Anodengebiet (18,22;64,66,68) und das Spannungserhaltungsgebiet (24,26;70,72) linear angeordnet sind, so dass das Kathodengebiet (28,30;58,60,62) an einem Ende der SCR-Einheit ist, das Gategebiet (16,20;50,52,54) sich an das Kathodengebiet (28,30;58,60,62) anschließt, das Spannungserhaltungsgebiet (24,26;70,72) sich an das Gategebiet (16,20;50,52,54) anschließt und das Anodengebiet (18,22;64,66,68) sich an das Spannungserhaltungsgebiet (24,26;70,72) anschließt und das Anodengebiet (18,22;64,66,68) an dem anderen Ende der SCR-Einheit abschließt,
**dadurch gekennzeichnet, dass**
die Siliziumschicht eine aus Polysilizium hergestellte Schicht ist, und
der SCR-Schalter eine elektrische Reihenschaltung aus n Einheitssiliziumgleichrichtern (12,14;42,44,46,48) aufweist, wobei n eine ganze Zahl größer gleich 2 ist und jeder Einheitsgleichrichter (12,14;42,44,46,48) eindeutig mit einer Ganzzahl zwischen 1 und n gekennzeichnet ist, wobei der Einheitsgleichrichter mit der Zahl 1 eine erste Einheit und der Einheitsgleichrichter mit der Zahl n eine letzte Einheit ist, einen Spannungsquellenknotenpunkt (34;74), n Widerstände (R1,R2;R10,R12,R14,R16), die jeweils eindeutig mit einer ganzen Zahl zwischen 1 und n bezeichnet sind, wobei der Widerstand mit der Bezeichnung 1 ein erster Widerstand und der Widerstand mit der Bezeichnung n ein n-ter Widerstand ist, wobei jeder Widerstand ein erstes Ende und ein zweites Ende aufweist und mit einem einzelnen Einheitsgleichrichter verknüpft ist, um ein Widerstands-Einheitssiliziumgleichrichterpaar zu bilden, wobei die Kathode (28;58), des ersten Einheitsgleichrichters (12;42) elektrisch mit dem ersten Ende des ersten Widerstands (R1;R16) und die Anode (22;68) des n-ten Einheitsgleichrichters (14;48) elektrisch mit dem zweiten Ende des n-ten Widerstands (R2;R10) und mit dem Spannungsknotenpunkt (34;74) verbunden ist, wobei die Anode (18;64,66) jedes i-ten Einheitsgleichrichters elektrisch verbunden mit und zumindest teilweise anschließend an die Kathode (30; 60,62) des (i+1)-ten Einheitsgleichrichters ist, wobei i jede ganze Zahl zwischen 1 und einschließlich n-1 ist und wobei das zweite Ende jedes i-ten Widerstands (R1;R16,R14,R12) elektrisch mit dem Gate (20;52,54) des (i+1)-ten Einheitsgleichrichters (14;44,46,48) und mit dem ersten Ende des (i+1)-ten Widerstands (R2;R14,R12,R10) verbunden ist.

2. Der Hochspannungssiliziumgleichrichterschalter (10) nach Anspruch 1, der eine elektrische Reihenschaltung aus ersten und zweiten Einheitsgleichrichtem (12,14) umfasst.

3. Der Siliziumgleichrichterschalter nach Anspruch 1, wobei das Substrat (80,82) Silizium (80) mit einer Isolationsschicht (82) an dessen oberer Oberfläche, die zwischen dem Silizium (80) und der Schicht (84) aus Polysilizium angeordnet ist, umfasst.

4. Der Siliziumgleichrichterschalter nach Anspruch 3, wobei die Isolationsschicht ein Oxid, ein Nitrid oder ein Oxynitrid umfasst.

5. Der Siliziumgleichrichterschalter nach Anspruch 1, wobei das Substrat (80) eines der folgenden Materialien umfasst: Glas, Keramik, Quarz oder Saphir.

6. Der Siliziumgleichrichterschalter nach einem der Ansprüche 1 bis 5, wobei das Gategebiet (16,20;50,52,54) und das Anodengebiet (18,22;64,66,68) Dotierkonzentrationen von ungefähr 10¹⁷ bis 10¹⁹ cm⁻³ aufweisen.

7. Der Siliziumgleichrichterschalter nach einem der Ansprüche 1 bis 6, wobei das Kathodengebiet (28,30;58,60,62) Dotierkonzentrationen von ungefähr 10¹⁹ bis 10²⁰ cm⁻³ aufweist.

8. Der Siliziumgleichrichterschalter nach Anspruch 1, wobei das Spannungserhaltungsgebiet (24,26;70,72) Dotierkonzentrationen von ungefähr 10¹⁸ bis 10¹⁴ cm⁻³ aufweist.

## Revendications

1. Commutateur à thyristor SCR (12, 14 ; 42, 44, 46, 48) comprenant :
un substrat (80, 82) avec une surface supérieure et une couche de silicium (84) formée sur le substrat (80, 82),
une unité à thyristor SCR (12, 14) étant formée dans ladite couche de silicium, où l'unité à thyristor comprend une région de grille (16, 20 ; 50, 52, 54), une région de cathode (28, 30 ; 58, 60, 62), une région d'anode (18, 22 ; 64, 66, 68), et une région d'entretien de tension (24, 26 ; 70, 72), la région de grille (16, 20 ; 50 ; 52 ; 54), la région de cathode (28, 30 ; 58, 60, 62), la région d'anode (18, 22 ; 64, 66, 68) et la région d'entretien de tension (24, 26 ; 70, 72) étant agencées de façon linéaire de sorte que la région de cathode (28, 30 ; 58, 60, 62) se situe au niveau d'une première extrémité de l'unité à thyristor SCR, la région de grille (16, 20 ; 50, 52, 54) est contiguë à la région de cathode (28, 30 ; 58, 60, 62), la région d'entretien de tension (2-4, 26 ; 70, 72) est contiguë à la région de grille (16, 20 ; 50, 52, 54), et la région d'anode (18, 22 ; 64, 66, 68) est contiguë à la région d'entretien de tension (24, 26 ; 70, 72) et la région d'anode (18, 22 ; 64, 66, 68) se termine à l'autre extrémité de l'unité à thyristor SCR,
**caractérisé en ce que**
ladite couche de silicium est une couche faite de polysilicium, et
le commutateur à thyristor SCR comprend une série électrique comportant n thyristors élémentaires (12, 14 ; 42, 44, 46, 48), où n est un nombre entier d'au moins 2 et chaque thyristor élémentaire (12, 14 ; 42, 44, 46, 48) est numéroté de façon unique avec un nombre entier entre 1 et n, le thyristor élémentaire numéroté 1 étant une première unité et le thyristor élémentaire numéroté n étant une dernière unité, un noeud de source de tension (34 ; 74), n résistances (R1, R2 ; R10, R12, R14, R16), chacun numéroté de façon unique avec un nombre entier entre 1 et n, la résistance numérotée 1 étant une première résistance et la résistance numérotée n étant une n^{ème} résistance, chaque résistance comportant une première extrémité et une seconde extrémité, et est associée à un seul thyristor élémentaire pour former une paire résistance-thyristor élémentaire, la cathode (28 ; 58) du premier thyristor élémentaire (12 ; 42) étant électriquement reliée à la première extrémité de la première résistance (R1 ; R16) et l'anode (22 ; 68) du n^{ème} thyristor élémentaire (14 ; 48) étant électriquement reliée à la seconde extrémité de la n^{ème} résistance (R2 ; R10) et au noeud de source de tension (34 ; 74), chaque i^{ème} thyristor élémentaire ayant son anode (18 ; 64, 66) électriquement reliée à la cathode (30 ; 60, 62) du (i+1)^{ème} thyristor élémentaire et au moins en partie contiguë à celle-ci, où i représente tous les entiers entre 1 et n-1 compris et chaque i^{ème} résistance (R1 ; R16, R14, R12) ayant sa seconde extrémité électriquement reliée à la grille (20 ; 52, 54) du (i+1)^{ème} thyristor élémentaire (14 ; 44, 46, 48) et à la première extrémité de la (i+1)^{ème} résistance (R2 ; R14, R12, R10).

2. Commutateur à thyristor à tension élevée (10) selon la revendication 1 comprenant une série électrique constituée de premier et second thyristor élémentaire (12, 14).

3. Commutateur à thyristor selon la revendication 1, dans lequel le substrat (80, 82) comprend du silicium (80) avec une couche isolante (82) sur la surface supérieure de celui-ci, interposée entre le silicium (80) et la couche (84) de polysilicium.

4. Commutateur à thyristor selon la revendication 3, dans lequel la couche isolante comprend un composé parmi les suivants : un oxyde, un nitrure ou un oxynitrure.

5. Commutateur à thyristor selon la revendication 1, dans lequel le substrat (80) comprend l'un des matériaux suivants : du verre, de la céramique, du quartz ou du saphir.

6. Commutateur à thyristor selon l'une quelconque des revendications 1 à 5, dans lequel la région de grille (16, 20 ; 50, 52, 54), et la région d'anode (18, 22 ; 64, 66, 68) présentent des concentrations en dopant se situant approximativement entre 10¹⁷ et 10¹⁹ cm⁻³.

7. Commutateur à thyristor selon l'une quelconque des revendications 1 à 6, dans lequel la région de cathode (28, 30 ; 58, 60, 62) présente des concentrations en dopant se situant approximativement entre 10¹⁹ et 10²⁰ cm⁻³.

8. Commutateur à thyristor selon la revendication 1, dans lequel la région d'entretien de tension (24, 26 ; 70, 72) présente des concentrations en dopant se situant approximativement entre 10¹⁸ et 10¹⁴ cm⁻³.
